(19) Europäisches Patentamt
European Patent Office
Office européen des brevets

(11) **EP 3 992 170 A1**

(12) **EUROPEAN PATENT APPLICATION**
published in accordance with Art. 153(4) EPC

(43) Date of publication:
**04.05.2022 Bulletin 2022/18**

(21) Application number: **20830668.8**

(22) Date of filing: **22.05.2020**

(51) International Patent Classification (IPC):
*C04B 37/02* (2006.01)     *H01L 23/12* (2006.01)
*H01L 23/14* (2006.01)

(52) Cooperative Patent Classification (CPC):
**H01L 23/3735; C04B 37/02; H01L 21/4871;**
**H01L 23/12; H01L 23/14; H01L 23/15;** H01L 23/473

(86) International application number:
**PCT/JP2020/020292**

(87) International publication number:
**WO 2020/261833 (30.12.2020 Gazette 2020/53)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **26.06.2019 JP 2019118505**

(71) Applicant: **Mitsubishi Materials Corporation**
**Tokyo 100-8117 (JP)**

(72) Inventor: **TERASAKI Nobuyuki**
**Saitama-shi, Saitama 330-8508 (JP)**

(74) Representative: **Hoffmann Eitle**
**Patent- und Rechtsanwälte PartmbB**
**Arabellastraße 30**
**81925 München (DE)**

(54) **COPPER/CERAMIC JOINED BODY, INSULATION CIRCUIT BOARD, COPPER/CERAMIC JOINED BODY PRODUCTION METHOD, AND INSULATION CIRCUIT BOARD MANUFACTURING METHOD**

(57)     This copper/ceramic bonded body includes a copper member made of copper or a copper alloy, and a ceramic member made of aluminum nitride, in which the copper member and the ceramic member are bonded to each other, and a Mg-O layer is formed at a bonding interface between the copper member and the ceramic member.

FIG. 2

**Description**

TECHNICAL FIELD

The present invention relates to a copper/ceramic joined body (a copper/ceramic bonded body) in which a copper member made of copper or a copper alloy and a ceramic member are bonded to each other, an insulation circuit board (an insulating circuit board) in which a copper sheet made of copper or a copper alloy is bonded to a surface of a ceramic substrate, a copper/ceramic joined body production method (a method for producing a copper/ceramic bonded body), and an insulation circuit board manufacturing method (a method for producing an insulating circuit board).

The present application claims priority on Japanese Patent Application No. 2019-118505 filed on June 26, 2019, the content of which is incorporated herein by reference.

BACKGROUND ART

A power module, an LED module, and a thermoelectric module have a structure in which a power semiconductor element, an LED element, and a thermoelectric element are bonded to an insulating circuit board, and in the insulating circuit board, a circuit layer made of a conductive material is formed on one surface of an insulating layer.

For example, a power semiconductor element for high-power control used for controlling a wind power generation, an electric vehicle, a hybrid vehicle, or the like has a large amount of heat generated during operation. Therefore, as a substrate on which the power semiconductor element is mounted, an insulating circuit board including a ceramic substrate and a circuit layer formed by bonding a metal sheet having excellent conductivity to one surface of the ceramic substrate has been widely used in the related art. As the insulating circuit board, one including a metal layer formed by bonding a metal sheet to the other surface of the ceramic substrate is also provided.

For example, Patent Document 1 proposes an insulating circuit board in which a circuit layer and a metal layer are formed by bonding a copper sheet to each of one surface and the other surface of a ceramic substrate. In Patent Document 1, the copper sheet is disposed on each of one surface and the other surface of the ceramic substrate with an Ag-Cu-Ti -based brazing material interposed therebetween, and the copper sheet is bonded thereto by performing a heating treatment (so-called active metal brazing method). In the active metal brazing method, since the brazing material containing Ti as an active metal is used, the wettability between the molten brazing material and the ceramic substrate is improved, and the ceramic substrate and the copper sheet are satisfactorily bonded to each other.

Patent Document 2 proposes an insulating circuit board in which a ceramic substrate and a copper sheet are bonded to each other by using a Cu-Mg-Ti-based brazing material.

In Patent Document 2, the ceramic substrate and the copper sheet are bonded to each other by heating at a temperature of 560°C to 800°C in a nitrogen gas atmosphere, and Mg in a Cu-Mg-Ti alloy is sublimated and Mg does not remain at a bonding interface, while titanium nitride (TiN) is not substantially formed.

By the way, in the circuit layer of the above-described insulating circuit board, a terminal material or the like may be ultrasonically bonded.

In the insulating circuit boards disclosed in Patent Documents 1 and 2, when ultrasonic waves are applied to bond the terminal material or the like, cracks are generated at the bonding interface, and there is a concern that the circuit layer may be peeled.

PRIOR ART DOCUMENTS

Patent Document

    Patent Document 1: Japanese Patent No. 3211856
    Patent Document 2: Japanese Patent No. 4375730

DISCLOSURE OF INVENTION

Problems to be Solved by the Invention

The present invention has been made in view of the above-described circumstances, and an object of the present invention is to provide a copper/ceramic bonded body, an insulating circuit board, a method for producing a copper/ceramic bonded body, and a method for producing an insulating circuit board, which can suppress peeling of a copper member from a ceramic member even when ultrasonic welding is performed.

Solutions for Solving the Problems

In order to solve the above-described problem, a copper/ceramic bonded body according to one aspect of the present invention includes a copper member made of copper or a copper alloy, and a ceramic member made of aluminum nitride, in which the copper member and the ceramic member are bonded to each other, and a Mg-O layer is formed at a bonding interface between the copper member and the ceramic member.

According to the copper/ceramic bonded body of the aspect of the present invention, since the Mg-O layer is formed at the bonding interface between the copper member and the ceramic member, Mg as a bonding material and an oxide formed on a surface of the ceramic member sufficiently react with each other, and the copper member and the ceramic member are firmly bonded to each other. Since the Mg-O layer is formed at the bonding interface, even when ultrasonic waves are applied, generation of cracks at the bonding interface can be suppressed, and thus peeling of the copper member from the ceramic member can be suppressed.

An insulating circuit board according to one aspect of the present invention includes a copper sheet made of copper or a copper alloy, and a ceramic substrate made of aluminum nitride, in which the copper sheet is bonded to a surface of the ceramic substrate, and a Mg-O layer is formed at a bonding interface between the copper sheet and the ceramic substrate.

According to the insulating circuit board of the aspect of the present invention, the Mg-O layer is formed at the bonding interface between the copper sheet and the ceramic substrate. Therefore, Mg as a bonding material and an oxide formed on the surface of the ceramic substrate sufficiently react with each other, and the copper sheet and the ceramic substrate are firmly bonded to each other. In addition, the Mg-O layer is formed at the bonding interface. Therefore, even when ultrasonic waves are applied, generation of cracks at the bonding interface can be suppressed, and peeling of the ceramic substrate from the copper sheet can be suppressed.

A method for producing a copper/ceramic bonded body according to one aspect of the present invention is a method for producing the copper/ceramic bonded body described above, the method includes a Mg disposing step of disposing Mg between the copper member and the ceramic member, a lamination step of laminating the copper member and the ceramic member with Mg interposed therebetween, and a bonding step of performing a heating treatment on the laminated copper member and ceramic member with Mg interposed therebetween in a state of being pressed in a lamination direction under a vacuum atmosphere to bond the copper member and the ceramic member to each other, in which, in the Mg disposing step, an amount of Mg is set to be in a range of 0.34 mg/cm$^2$ or more and 4.35 mg/cm$^2$ or less, and in the bonding step, a temperature increase rate in a temperature range of 480°C or higher and lower than 650°C is set to be 5 °C/min or higher, and heating is held at a temperature of 650°C or higher for 30 minutes or longer.

According to the method for producing a copper/ceramic bonded body of the aspect of the present invention, in the Mg disposing step, the amount of Mg is set to be in the range of 0.34 mg/cm$^2$ or more and 4.35 mg/cm$^2$ or less. Therefore, a Cu-Mg liquid phase required for an interfacial reaction can be sufficiently obtained. Accordingly, the copper member and the ceramic member can be reliably bonded to each other.

In the bonding step, the temperature increase rate in the temperature range of 480°C or higher and lower than 650°C is set to be 5 °C/min or higher, and heating is held at the temperature of 650°C or higher for 30 minutes or longer. Therefore, the Cu-Mg liquid phase required for an interfacial reaction can be held for a certain period of time or longer, a uniform interfacial reaction can be promoted, and the Mg-O layer can be reliably formed at the bonding interface between the copper member and the ceramic member.

A method for producing an insulating circuit board according to one aspect of the present invention is a method for producing the insulating circuit board described above, the method includes a Mg disposing step of disposing Mg between the copper sheet and the ceramic substrate, a lamination step of laminating the copper sheet and the ceramic substrate with Mg interposed therebetween, and a bonding step of performing a heating treatment on the laminated copper sheet and ceramic substrate with Mg interposed therebetween in a state of being pressed in a lamination direction under a vacuum atmosphere to bond the copper sheet and the ceramic substrate to each other, in which, in the Mg disposing step, an amount of Mg is set to be in a range of 0.34 mg/cm$^2$ or more and 4.35 mg/cm$^2$ or less, and in the bonding step, a temperature increase rate in a temperature range of 480°C or higher and lower than 650°C is set to be 5 °C/min or higher, and heating is held at a temperature of 650°C or higher for 30 minutes or longer.

According to the method for producing an insulating circuit board of the aspect of the present invention, in the Mg disposing step, the amount of Mg is set to be in the range of 0.34 mg/cm$^2$ or more and 4.35 mg/cm$^2$ or less. Therefore, a Cu-Mg liquid phase required for an interfacial reaction can be sufficiently obtained. Accordingly, the copper sheet and the ceramic substrate can be reliably bonded to each other.

In the bonding step, the temperature increase rate in the temperature range of 480°C or higher and lower than 650°C is set to be 5 °C/min or higher, and heating is held at the temperature of 650°C or higher for 30 minutes or longer. Therefore, the Cu-Mg liquid phase required for an interfacial reaction can be held for a certain period of time or longer, a uniform interfacial reaction can be promoted, and the Mg-O layer can be reliably formed at the bonding interface between the copper sheet and the ceramic substrate.

Effects of Invention

According to one aspect of the present invention, it is possible to provide a copper/ceramic bonded body, an insulating circuit board, a method for producing a copper/ceramic bonded body, and a method for producing an insulating circuit board, which can suppress peeling of a copper member from a ceramic member even when ultrasonic welding is performed.

BRIEF DESCRIPTION OF DRAWINGS

FIG. 1 is a schematic explanatory view of a power module using an insulating circuit board according to an embodiment of the present invention.
FIG. 2 is an enlarged explanatory view of a bonding interface between a circuit layer (metal layer) and a ceramic substrate of the insulating circuit board according to the embodiment of the present invention.
FIG. 3 is an observation result of the bonding interface between the circuit layer (metal layer) and the ceramic substrate of the insulating circuit board according to the embodiment of the present invention.
FIG. 4A is a graph showing a line analysis result of the bonding interface between the circuit layer (metal layer) and the ceramic substrate of the insulating circuit board according to the embodiment of the present invention.
FIG. 4B is an enlarged graph of a part of the vertical axis of FIG. 4A.
FIG. 5 is a flowchart of a method for producing the insulating circuit board according to the embodiment of the present invention.
FIG. 6 is a schematic explanatory view of the method for producing the insulating circuit board according to the embodiment of the present invention.

EMBODIMENTS FOR CARRYING OUT THE INVENTION

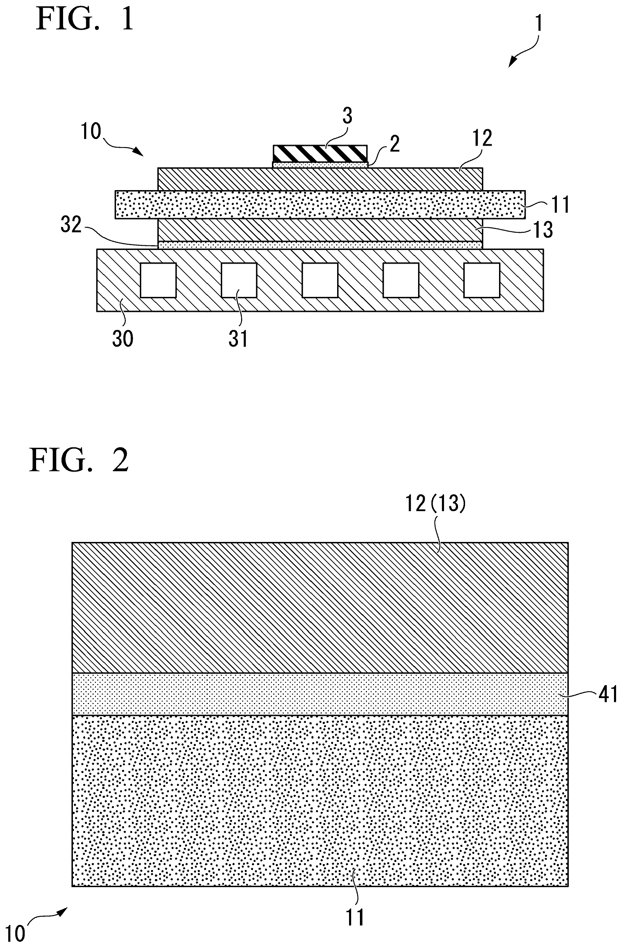

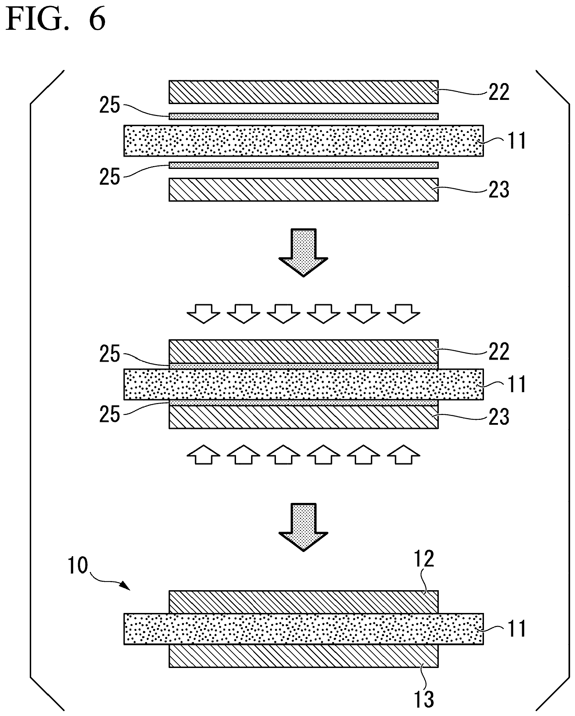

Hereinafter, an embodiment of the present invention will be described with reference to the accompanying drawings.
A copper/ceramic bonded body according to the present embodiment is an insulating circuit board 10 including a ceramic substrate 11 as a ceramic member made of ceramics (aluminum nitride), and a copper sheet 22 (circuit layer 12) and a copper sheet 23 (metal layer 13) as a copper member made of copper or a copper alloy. The copper sheet 22 (circuit layer 12) and the copper sheet 23 (metal layer 13) are bonded to the ceramic substrate 11. FIG. 1 shows a power module 1 including an insulating circuit board 10 according to the present embodiment.
The power module 1 includes the insulating circuit board 10 on which the circuit layer 12 and the metal layer 13 are disposed, a semiconductor element 3 bonded to one surface (upper surface in FIG. 1) of the circuit layer 12 with a bonding layer 2 interposed therebetween, and a heat sink 30 disposed on the other side (lower side in FIG. 1) of the metal layer 13.
The semiconductor element 3 is made of a semiconductor material such as Si or the like. The semiconductor element 3 and the circuit layer 12 are bonded to each other with the bonding layer 2 interposed therebetween.
The bonding layer 2 is made of, for example, a Sn-Ag-based, Sn-In-based, or Sn-Ag-Cu-based solder material.
The heat sink 30 dissipates heat from the insulating circuit board 10 described above. The heat sink 30 is made of copper or a copper alloy, and in the present embodiment, the heat sink 30 is made of phosphorus-deoxidized copper. The heat sink 30 is provided with a passage 31 through which a cooling fluid flows.
In the present embodiment, the heat sink 30 and the metal layer 13 are bonded to each other by a solder layer 32 made of a solder material. The solder layer 32 is made of, for example, a Sn-Ag-based, Sn-In-based, or Sn-Ag-Cu-based solder material.
As shown in FIG. 1, the insulating circuit board 10 of the present embodiment includes the ceramic substrate 11, the circuit layer 12 disposed on one surface (upper surface in FIG. 1) of the ceramic substrate 11, and the metal layer 13 disposed on the other surface (lower surface in FIG. 1) of the ceramic substrate 11.
The ceramic substrate 11 is made of aluminum nitride (AlN) having excellent insulating properties and heat dissipation. The thickness of the ceramic substrate 11 is set to be in a range of, for example, 0.2 mm or more and 1.5 mm or less, and in the present embodiment, the thickness is set to 0.635 mm.
As shown in FIG. 6, the circuit layer 12 is formed by bonding the copper sheet 22 made of copper or a copper alloy to one surface (upper surface in FIG. 6) of the ceramic substrate 11.
In the present embodiment, the circuit layer 12 is formed by bonding the copper sheet 22 made of a rolled sheet of oxygen-free copper to the ceramic substrate 11.
The thickness of the copper sheet 22 serving as the circuit layer 12 is set to be in a range of 0.1 mm or more and 2.0 mm or less, and in the present embodiment, the thickness is set to 0.6 mm.

As shown in FIG. 6, the metal layer 13 is formed by bonding the copper sheet 23 made of copper or a copper alloy to the other surface (lower surface in FIG. 6) of the ceramic substrate 11.

In the present embodiment, the metal layer 13 is formed by bonding the copper sheet 23 made of a rolled sheet of oxygen-free copper to the ceramic substrate 11.

The thickness of the copper sheet 23 serving as the metal layer 13 is set to be in a range of 0.1 mm or more and 2.0 mm or less, and in the present embodiment, the thickness is set to 0.6 mm.

As shown in FIG. 2, a Mg-O layer 41 is formed at the bonding interface between the ceramic substrate 11 and the circuit layer 12 (metal layer 13).

The Mg-O layer 41 is formed by reacting Mg used as a bonding material with an oxide film formed on the surface of the ceramic substrate 11.

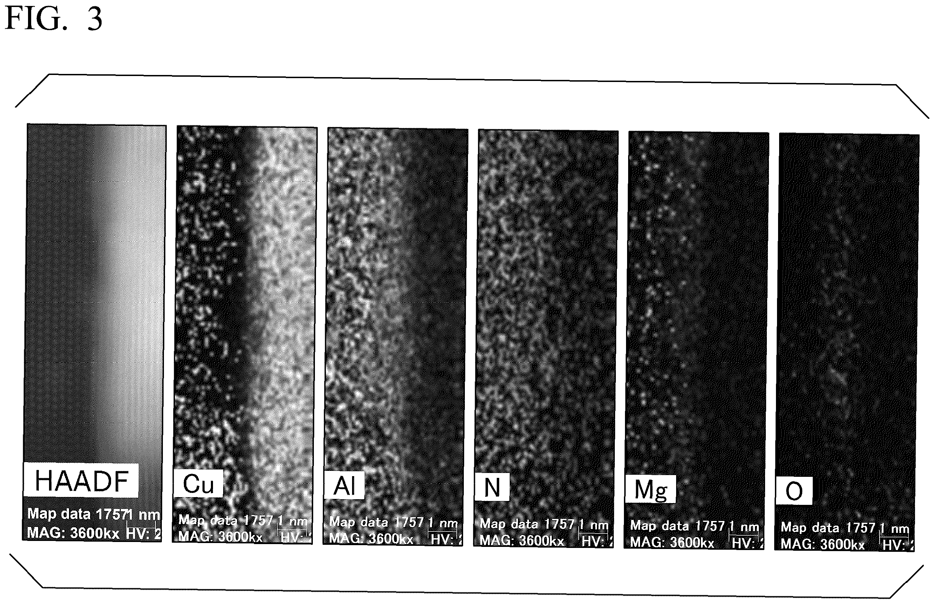

FIG. 3 shows observation results of the bonding interface between the ceramic substrate 11 and the circuit layer 12 (metal layer 13). Specifically, FIG. 3 shows a high-angle annular dark field scanning TEM (HAADF-STEM) image of the bonding interface and composition distribution observation results (element mapping results) obtained by an energy dispersive X-ray spectroscopy (EDX) method. The figure labeled "HAADF" at the left end of FIG. 3 is a HAADF-STEM image of the bonding interface. The HAADF image is a Z contrast image, and in the HAADF image, a contrast proportional to an atomic weight (Z) is obtained, so that heavy elements are displayed brightly (white). In the figure, the ceramic substrate (AlN) 11 is located on the left side, the circuit layer (Cu) 12 is located on the right side, and the right side is displayed brightly (white). In FIG. 3, the figures labeled "Cu", "Al", "N", "Mg", and "O" are the distribution observation results of each element obtained by the EDX method. The distribution observation results of each element obtained by the EDX method correspond to the HAADF-STEM image. In the distribution observation results of each element, the larger the amount of detected elements is, the brighter (whiter) the elements are displayed. In FIG. 3, the region where Al and N are detected corresponds to the ceramic substrate 11, and the region where Cu is detected is the circuit layer 12 (metal layer 13). It is confirmed that the Mg-O layer 41 in which Mg and O are unevenly distributed is present between the ceramic substrate 11 and the circuit layer 12 (metal layer 13).

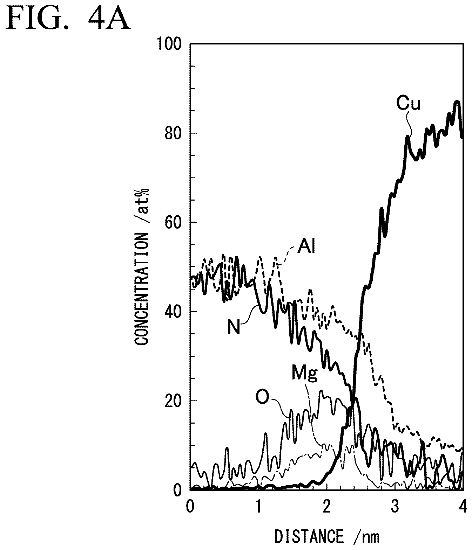

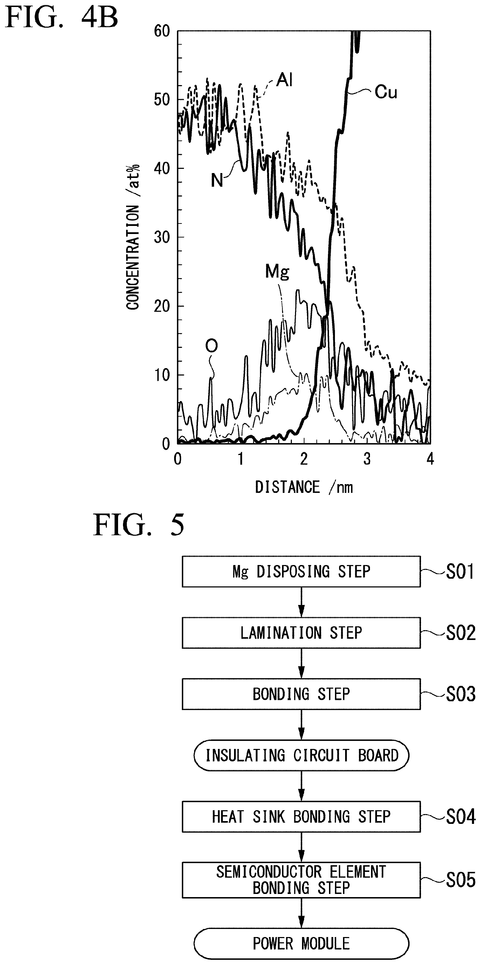

In addition, line analysis results of the bonding interface between the ceramic substrate 11 and the circuit layer 12 (metal layer 13) are shown in FIGS. 4A and 4B. A line profile of the bonding interface in a thickness direction from the ceramic substrate 11 to the circuit layer 12 was obtained using an energy dispersive X-ray analyzer (EDX, NSS7 manufactured by Thermo Fisher Scientific K.K.) attached to a scanning transmission electron microscope (STEM, Titan ChemiSTEM manufactured by FEI Company) under conditions where an acceleration voltage was 200 kV and a magnification was 3.6 million. The line profile is a graph obtained with the vertical axis representing a concentration of the element and the horizontal axis representing a moving distance of a measurement point (position of the measurement point). The concentration of the element is a ratio (atomic%) of the amount of the element to the total amount (100 atomic%) of Al, N, O, Mg, and Cu measured at a certain measurement point. In FIGS. 4A and 4B, the region where the concentrations of Al and N are high corresponds to the ceramic substrate 11, and the region where the concentration of Cu is high is the circuit layer 12 (metal layer 13). In the regions (that is, the bonding interfaces) where the concentrations of Al and N and the concentration of Cu change, the concentrations of Mg and O increase, and it is confirmed that the Mg-O layer 41 in which Mg and O are unevenly distributed is present.

In the present embodiment, in a case where Mg and O are present in the same region in the distribution observation results (element mapping results) of Mg and O at the bonding interface shown in FIG. 3 and in the line profiles of the bonding interfaces shown in FIGS. 4A and 4B, it is determined that the Mg-O layer 41 is present at the bonding interface. In addition, as described below, in a case where the bonding interface is observed with atomic resolution and the Mg-O layer 41 having a thickness equal to or larger than a thickness of an O-Mg-O monolayer structure is confirmed, it is also confirmed that the Mg-O layer 41 is present at the bonding interface. The Mg-O layer 41 is preferably present on the entire surface of the bonding interface between the ceramic substrate 11 and the circuit layer 12 (metal layer 13).

It can be said that the thickness of the Mg-O layer 41 is a thickness of the region where both the Mg concentration and the O concentration are 5 at% (atomic%) or more in the regions where the Mg concentration and the O concentration overlap in the line profiles shown in FIGS. 4A and 4B measured by energy dispersive X-ray spectroscopy (EDX). Each of the Mg concentration and the O concentration is a ratio (atomic%) of the amount of Mg or O to the total amount (100 atomic%) of Al, N, O, Mg, and Cu. The upper limit of the thickness of the Mg-O layer 41 is preferably 50 nm or less, more preferably 25 nm or less, and still more preferably 15 nm or less. The lower limit of the thickness of the Mg-O layer 41 is not particularly limited. Considering the resolution of EDX, the thickness of the Mg-O layer 41 obtained by the above-described method is 1 nm or more.

Even in a case where the Mg concentration and the O concentration are low and the thickness of the Mg-O layer 41 obtained by the above method is less than 1 nm, the Mg-O layer 41 having a thickness in a range of the thickness of the O-Mg-O monolayer structure to 0.5 nm can be confirmed by observing the bonding interface with atomic resolution at a level where an atomic position can be directly specified. Therefore, it can be said that the lower limit of the thickness of the Mg-O layer 41 is equal to or more than the thickness of the O-Mg-O monolayer structure. In a case where the thickness of the Mg-O layer 41 is equal to or more than the thickness of the O-Mg-O monolayer structure, the effects of the present embodiment can be obtained. In a case where a coordination number is 6, an ionic radius of $Mg^{2+}$ is 0.72 angstroms. In a case where a coordination number is 2 to 8, an ionic radius of $O^{2-}$ is 1.35 to 1.42 angstroms. Assuming that a crystal structure of MgO is a rock-salt type and considering that there is a relationship of AlN (0001)//MgO(111) and that a coordination number of O in the Mg-O layer 41 may be different from a coordination number of O in a bulk body of MgO, the thickness of the O-Mg-O monolayer structure is 0.395 to 0.411 nm, which is about 0.4 nm. In this way, in a case where the bonding interface is observed with atomic resolution, the thickness of the Mg-O layer 41 is calculated from the average number of ions arranged in the thickness direction, the ionic radius, and the crystal structure.

In summary, the thickness of the Mg-O layer 41 is obtained from the line profile measured by EDX by the method described above. In a case where the obtained thickness of the Mg-O layer 41 is less than 1 nm, a more accurate thickness of the Mg-O layer 41 is obtained by observing the bonding interface with atomic resolution.

Hereinafter, a method for producing the insulating circuit board 10 according to the present embodiment will be described with reference to FIGS. 5 and 6.

(Mg Disposing Step S01)

First, the ceramic substrate 11 made of aluminum nitride (AlN) is prepared, and as shown in FIG. 6, Mg is disposed between the copper sheet 22 serving as the circuit layer 12 and the ceramic substrate 11, and between the copper sheet 23 serving as the metal layer 13 and the ceramic substrate 11.

In the present embodiment, a Mg foil 25 is disposed between the copper sheet 22 serving as the circuit layer 12 and the ceramic substrate 11, and between the copper sheet 23 serving as the metal layer 13 and the ceramic substrate 11.

In the Mg disposing step S01, the amount of Mg to be disposed is set to be in a range of 0.34 mg/cm$^2$ or more and 4.35 mg/cm$^2$ or less.

The lower limit of the amount of Mg to be disposed is preferably 0.52 mg/cm$^2$ or more, and more preferably 0.69 mg/cm$^2$ or more. On the other hand, the upper limit of the amount of Mg to be disposed is preferably 3.48 mg/cm$^2$ or less, and more preferably 2.61 mg/cm$^2$ or less.

(Lamination Step S02)

Next, the copper sheet 22 and the ceramic substrate 11 are laminated with the Mg foil 25 interposed therebetween, and the ceramic substrate 11 and the copper sheet 23 are laminated with the Mg foil 25 interposed therebetween.

(Bonding Step S03)

Next, while the copper sheet 22, the Mg foil 25, the ceramic substrate 11, the Mg foil 25, and the copper sheet 23 which are laminated are pressed in a lamination direction, they are loaded into a vacuum furnace and heated such that the copper sheet 22, the ceramic substrate 11, and the copper sheet 23 are bonded together.

A heating treatment condition in the bonding step S03 is such that a temperature increase rate in a temperature range of 480°C or higher and lower than 650°C is set to be 5 °C/min or higher and that heating is held at a temperature of 650°C or higher for 30 minutes or longer. By defining the heating treatment condition in this way, the Cu-Mg liquid phase can be maintained in a high temperature state, the interfacial reaction is promoted, whereby the Mg-O layer 41 described above is formed.

The lower limit of the temperature increase rate in the temperature range of 480°C or higher and lower than 650°C is preferably 7 °C/min or higher, and more preferably 9 °C/min or higher. On the other hand, the upper limit of the temperature increase rate in the temperature range of 480°C or higher and lower than 650°C is not particularly limited, but is preferably 30 °C/min or lower, more preferably 15 °C/min or lower, and still more preferably 12 °C/min or lower.

In addition, the lower limit of the holding temperature is preferably 700°C or higher, and more preferably 720°C or higher. On the other hand, the upper limit of the holding temperature is not particularly limited, but is preferably 850°C or lower, and more preferably 830°C or lower.

Further, the lower limit of the holding time is preferably 45 minutes or longer, and more preferably 60 minutes or longer. On the other hand, the upper limit of the holding time is not particularly limited, but is preferably 180 minutes or shorter, and more preferably 150 minutes or shorter.

A pressing load in the bonding step S03 is preferably in a range of 0.049 MPa or more and 3.4 MPa or less. The upper limit of the pressing load is more preferably 2.0 MPa or less, and still more preferably 1.5 MPa or less. The lower limit of the pressing load is more preferably 0.19 MPa or more, and still more preferably 0.39 MPa or more.

Further, a degree of vacuum in the bonding step S03 is preferably in a range of $1\times10^{-6}$ Pa or more and $5\times10^{-2}$ Pa or less. The upper limit of the degree of vacuum is more preferably $1\times10^{-2}$ Pa or less, and still more preferably $5\times10^{-3}$ Pa or less. The lower limit of the degree of vacuum is more preferably $1\times10^{-5}$ Pa or more, and still more preferably $1\times10^{-4}$ Pa or more.

As described above, the insulating circuit board 10 according to the present embodiment is produced by the Mg disposing step S01, the lamination step S02, and the bonding step S03.

(Heat Sink Bonding Step S04)

Next, the heat sink 30 is bonded to the other surface side of the metal layer 13 of the insulating circuit board 10.

The insulating circuit board 10 and the heat sink 30 are laminated with a solder material interposed therebetween and are loaded into a heating furnace such that the insulating circuit board 10 and the heat sink 30 are solder-bonded to each other with the solder layer 32 interposed therebetween.

(Semiconductor Element Bonding Step S05)

Next, the semiconductor element 3 is bonded to one surface of the circuit layer 12 of the insulating circuit board 10 by soldering.

The power module 1 shown in FIG. 1 is produced by the above steps.

According to the insulating circuit board 10 (copper/ceramic bonded body) of the present embodiment having the above configuration, the Mg-O layer 41 is formed at the bonding interface between the circuit layer 12 (or the metal layer 13) and the ceramic substrate 11. Therefore, Mg as a bonding material and an oxide formed on the surface of the ceramic substrate 11 sufficiently react with each other, and the circuit layer 12 (or the metal layer 13) and the ceramic substrate 11 are firmly bonded to each other. In addition, since the Mg-O layer 41 is formed at the bonding interface, even when ultrasonic waves are applied, generation of cracks at the bonding interface can be suppressed, and thus peeling of the circuit layer 12 (or the metal layer 13) from the ceramic substrate 11 can be suppressed.

According to the method for producing the insulating circuit board 10 (copper/ceramic bonded body) of the present embodiment, in the Mg disposing step S01, the amount of Mg to be disposed between the copper sheet 22 (or the copper sheet 23) and the ceramic substrate 11 is set to be in a range of 0.34 mg/cm$^2$ or more and 4.35 mg/cm$^2$ or less. Therefore, the Cu-Mg liquid phase required for the interfacial reaction can be sufficiently obtained. Accordingly, the copper sheet 22 (or the copper sheet 23) and the ceramic substrate 11 can be reliably bonded to each other, and the bonding strength between the circuit layer 12 (or the metal layer 13) and the ceramic substrate 11 can be ensured.

In the bonding step S03, the temperature increase rate in the temperature range of 480°C or higher and lower than 650°C is set to be 5 °C/min or higher, and heating is held at the temperature of 650°C or higher for 30 minutes or longer. Therefore, between the copper sheet 22 (or the copper sheet 23) and the ceramic substrate 11, the Cu-Mg liquid phase required for the interfacial reaction can be held for a certain period of time or longer, and a uniform interfacial reaction can be promoted. As a result, the Mg-O layer 41 can be reliably formed at the bonding interface between the circuit layer 12 (or the metal layer 13) and the ceramic substrate 11.

The embodiment of the present invention has been described, but the present invention is not limited thereto, and can be appropriately changed without departing from the technical features of the present invention.

For example, in the present embodiment, the insulating circuit board has been described as a member constituting the power module in which the semiconductor element is mounted on the insulating circuit board, but the present invention is not limited thereto. For example, the insulating circuit board may be a member constituting an LED module in which an LED element is mounted on the circuit layer of the insulating circuit board, or may be a member constituting a thermoelectric module in which a thermoelectric element is mounted on the circuit layer of the insulating circuit board.

In the insulating circuit board of the present embodiment, it has been described that the circuit layer and the metal layer are both composed of a copper sheet made of copper or a copper alloy, but the present invention is not limited thereto.

For example, in a case where the circuit layer and the ceramic substrate are the copper/ceramic bonded body of the present embodiment, the material and bonding method of the metal layer are not particularly limited. For example, there may be no metal layer, the metal layer may be made of aluminum or an aluminum alloy, or may be a laminate of copper and aluminum.

On the other hand, in a case where the metal layer and the ceramic substrate are the copper/ceramic bonded body of the present embodiment, the material and bonding method of the circuit layer are not particularly limited. For example, the circuit layer may be made of aluminum or an aluminum alloy, or may be a laminate of copper and aluminum.

Further, in the present embodiment, it has been described that the Mg foil is laminated between the copper sheet and the ceramic substrate in the Mg disposing step, but the present invention is not limited thereto, and a thin film made of Mg may be formed on the bonding surface of the ceramic substrate and the copper sheet by a sputtering method, a vapor deposition method, or the like.

EXAMPLES

Hereinafter, results of confirmation experiments performed to confirm the effects of the present embodiment will be described.

First, a ceramic substrate (40 mm × 40 mm × 0.635 mm) made of aluminum nitride (AIN) was prepared.

A copper sheet (37 mm × 37 mm × thickness of 0.3 mm) made of oxygen-free copper was laminated on both surfaces of the ceramic substrate with a Mg foil interposed therebetween. The copper sheet and the ceramic substrate were heat-treated and bonded to each other under the conditions shown in Table 1 to obtain an insulating circuit board (copper/ceramic bonded body). A degree of vacuum of a vacuum furnace at the time of bonding was set to be $5 \times 10^{-3}$ Pa.

The insulating circuit board (copper/ceramic bonded body) thus obtained was evaluated for the presence or absence of a Mg-O layer at a bonding interface, an initial bonding rate, breaking in the ceramic substrate after thermal cycle loading, and an ultrasonic welding property as follows.

(Mg-O Layer)

An observation sample was taken from the central part of the bonding interface between the copper sheet and the ceramic substrate in a cross section of the obtained insulating circuit board (copper/ceramic bonded body) along the laminating direction of the copper sheet and the ceramic substrate. The bonding interface between the copper sheet and the ceramic substrate was measured using a scanning transmission electron microscope (Titan ChemiSTEM manufactured by FEI Company) at an acceleration voltage of 200 kV and a magnification of 80000, and the element mapping of Mg and O was acquired based on an energy dispersive X-ray analysis method (NSS7 manufactured by Thermo Fisher Scientific K.K.). In a case where Mg and O were present in the same region, it was determined that the Mg-O layer was present.

(Initial Bonding Rate)

A bonding rate between the copper sheet and the ceramic substrate was evaluated. Specifically, in the insulating circuit board, a bonding rate at the interface between the copper sheet and the ceramic substrate was evaluated using an ultrasonic flaw detector (FineSAT200 manufactured by Hitachi Power Solutions Co., Ltd.), and the initial bonding rate was calculated from the following equation. An initial bonding area was an area to be bonded before bonding, that is, an area of the circuit layer. In an image obtained by binarizing an ultrasonic flaw detection image, peeling was indicated by a white portion in the bonding part, and thus the area of the white portion was regarded as a peeled area (non-bonded part area).

$$\text{(Initial bonding rate)} = \{\text{(initial bonding area) - (non-bonded part area)}\} / \text{(initial}$$

$$\text{bonding area)} \times 100$$

(Breaking in Ceramic Substrate after Thermal Cycle Loading)

A freezer and a heating furnace were prepared, and the temperature inside each was set to the following. The obtained insulating circuit board (copper/ceramic bonded body) was held in a freezer at -78°C for 2 minutes, and then was held in a heating furnace at 350°C for 2 minutes. This work was repeated 10 times. After that, by scanning acoustic tomography (SAT) inspection, the bonding interface between the copper sheet and the ceramic substrate was inspected, and the presence or absence of ceramic breaking was determined. The SAT inspection is an inspection for obtaining an ultrasonic flaw detection image of the bonding interface using an ultrasonic flaw detector. The evaluation results are shown in the item "Presence or absence of ceramic breaking" in Table 1.

$$-78°C \times 2 \text{ minutes} \leftarrow \rightarrow 350°C \times 2 \text{ minutes } 10 \text{ times}$$

(Ultrasonic Welding Property)

A copper terminal (10 mm × 5 mm × 1 mm thick) was ultrasonically bonded to the obtained insulating circuit board (copper/ceramic bonded body) using an ultrasonic metal bonding machine (60C-904 manufactured by Ultrasonic Engineering Co., Ltd.) under the condition where a collapse amount was 0.3 mm.

After bonding, the bonding interface between the copper sheet and the ceramic substrate was inspected using an ultrasonic flaw detector (FineSAT200 manufactured by Hitachi Power Solutions Co., Ltd.). Those in which peeling or ceramic breaking was observed were evaluated as "X" (poor), those in which neither peeling nor ceramic breaking was confirmed were evaluated as "O" (good). The evaluation results are shown in Table 1.

Table 1

| | Mg disposing step | Bonding step | | | | | Bonding interface | Initial bonding rate % | Presence or absence of ceramic breaking | Ultrasonic welding property |
|---|---|---|---|---|---|---|---|---|---|---|
| | Amount of Mg mg/cm$^2$ | Load MPa | Temperature increase rate*1 °C/min | Holding temperature °C | Holding time min | | Mg-O layer | | | |
| Invention Example 1 | 0.70 | 0.49 | 5 | 650 | 30 | | Present | 96.0 | Absent | O |
| Invention Example 2 | 1.04 | 3.43 | 10 | 800 | 60 | | Present | 95.0 | Absent | O |
| Invention Example 3 | 0.70 | 1.47 | 20 | 800 | 180 | | Present | 95.3 | Absent | O |
| Invention Example 4 | 1.74 | 0.294 | 30 | 850 | 150 | | Present | 94.3 | Absent | O |
| Invention Example 5 | 4.35 | 0.098 | 30 | 850 | 60 | | Present | 94.4 | Absent | O |
| Invention Example 6 | 0.35 | 0.294 | 5 | 750 | 180 | | Present | 96.8 | Absent | O |
| Invention Example 7 | 2.61 | 0.294 | 5 | 850 | 150 | | Present | 99.0 | Absent | O |
| Invention Example 8 | 0.52 | 0.294 | 30 | 800 | 30 | | Present | 97.4 | Absent | O |
| Comparative Example | 2.61 | 0.294 | 3 | 850 | 150 | | Absent | 90.3 | Present | X |

*1: Temperature increase rate: average temperature increase rate in temperature range of 480°C or higher and lower than 650°C

In the comparative example in which the temperature increase rate in the temperature range of 480°C or higher and lower than 650°C was set to 3 °C/min, the Mg-O layer was not formed at the bonding interface. Therefore, the initial bonding rate was low, and ceramic breaking was generated at the time of thermal cycle loading. Further, when ultrasonic welding was performed, peeling of the copper sheet from the ceramic substrate was observed.

On the other hand, in Invention Examples 1 to 8 in which the Mg-O layer was formed at the bonding interface, the initial bonding rate was high, and the ceramic substrate and the copper sheet could be firmly bonded to each other. In addition, generation of ceramic breaking after thermal cycle loading was suppressed, and the thermal cycle reliability was excellent. Further, when ultrasonic welding was performed, peeling of the copper sheet from the ceramic substrate was not observed, and the ultrasonic welding property was excellent.

As a result, according to the Invention Examples, it was confirmed that it is possible to provide a copper/ceramic bonded body, an insulating circuit board, a method for producing a copper/ceramic bonded body, and a method for producing an insulating circuit board, which can suppress peeling of a copper member from a ceramic member even when ultrasonic welding is performed.

Industrial Applicability

According to the present embodiment, it is possible to provide a copper/ceramic bonded body (insulating circuit board) capable of suppressing peeling of a copper member from a ceramic member even when ultrasonic welding is performed. Therefore, the present embodiment can be suitably applied to a power module, an LED module, or a thermoelectric module in which a power semiconductor element, an LED element, or a thermoelectric element is bonded to an insulating circuit board.

Explanation of Reference Signs

10:    Insulating circuit board (copper/ceramic bonded body)
11:    Ceramic substrate (ceramic member)
12:    Circuit layer (copper member)
13:    Metal layer (copper member)
41:    Mg-O layer

**Claims**

1.    A copper/ceramic bonded body comprising:

   a copper member made of copper or a copper alloy; and
   a ceramic member made of aluminum nitride,
   wherein the copper member and the ceramic member are bonded to each other, and
   a Mg-O layer is formed at a bonding interface between the copper member and the ceramic member.

2.    An insulating circuit board comprising:

   a copper sheet made of copper or a copper alloy; and
   a ceramic substrate made of aluminum nitride,
   wherein the copper sheet is bonded to a surface of the ceramic substrate, and
   a Mg-O layer is formed at a bonding interface between the copper sheet and the ceramic substrate.

3.    A method for producing the copper/ceramic bonded body according to Claim 1, the method comprising:

   a Mg disposing step of disposing Mg between the copper member and the ceramic member;
   a lamination step of laminating the copper member and the ceramic member with Mg interposed therebetween; and
   a bonding step of performing a heating treatment on the laminated copper member and ceramic member with Mg interposed therebetween in a state of being pressed in a lamination direction under a vacuum atmosphere to bond the copper member and the ceramic member to each other,
   wherein, in the Mg disposing step, an amount of Mg is set to be in a range of 0.34 mg/cm$^2$ or more and 4.35

mg/cm$^2$ or less, and

in the bonding step, a temperature increase rate in a temperature range of 480°C or higher and lower than 650°C is set to be 5 °C/min or higher, and heating is held at a temperature of 650°C or higher for 30 minutes or longer.

4. A method for producing the insulating circuit board according to Claim 2, the method comprising:

a Mg disposing step of disposing Mg between the copper sheet and the ceramic substrate;

a lamination step of laminating the copper sheet and the ceramic substrate with Mg interposed therebetween; and

a bonding step of performing a heating treatment on the laminated copper sheet and ceramic substrate with Mg interposed therebetween in a state of being pressed in a lamination direction under a vacuum atmosphere to bond the copper sheet and the ceramic substrate to each other,

wherein, in the Mg disposing step, an amount of Mg is set to be in a range of 0.34 mg/cm$^2$ or more and 4.35 mg/cm$^2$ or less, and

in the bonding step, a temperature increase rate in a temperature range of 480°C or higher and lower than 650°C is set to be 5 °C/min or higher, and heating is held at a temperature of 650°C or higher for 30 minutes or longer.

## FIG. 1

## FIG. 2

FIG. 3

FIG. 4A

FIG. 4B

FIG. 5

```
┌─────────────────────────┐
│   Mg DISPOSING STEP     │──S01
└─────────────────────────┘
            │
            ▼
┌─────────────────────────┐
│     LAMINATION STEP     │──S02
└─────────────────────────┘
            │
            ▼
┌─────────────────────────┐
│      BONDING STEP       │──S03
└─────────────────────────┘
            │
            ▼
   ( INSULATING CIRCUIT BOARD )
            │
            ▼
┌─────────────────────────┐
│   HEAT SINK BONDING STEP│──S04
└─────────────────────────┘
            │
            ▼
┌─────────────────────────┐
│  SEMICONDUCTOR ELEMENT  │──S05
│     BONDING STEP        │
└─────────────────────────┘
            │
            ▼
      ( POWER MODULE )
```

## FIG. 6

## INTERNATIONAL SEARCH REPORT

| | International application No. |
|---|---|
| | PCT/JP2020/020292 |

**A. CLASSIFICATION OF SUBJECT MATTER**
Int. Cl. C04B37/02(2006.01)i, H01L23/12(2006.01)i, H01L23/14(2006.01)i
FI: C04B37/02 A, H01L23/12 D, H01L23/14 M

According to International Patent Classification (IPC) or to both national classification and IPC

**B. FIELDS SEARCHED**

Minimum documentation searched (classification system followed by classification symbols)
Int. Cl. C04B37/02, H01L23/12, H01L23/14

Documentation searched other than minimum documentation to the extent that such documents are included in the fields searched
Published examined utility model applications of Japan      1922-1996
Published unexamined utility model applications of Japan    1971-2020
Registered utility model specifications of Japan            1996-2020
Published registered utility model applications of Japan    1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 11-343178 A (FUJI ELECTRIC CO., LTD.) 14 December 1999, claims, examples, paragraph [0046], December 1999, claims, examples, paragraph [0046] | 1-2 |
| A | | 3-4 |
| X | JP 9-82843 A (TOSHIBA CORP.) 28 March 1997, claims, paragraphs [0016], [0019], [0035], claims, paragraphs [0016], [0019], [0035] | 1-2 |
| A | | 3-4 |
| A | JP 2018-140929 A (MITSUBISHI MATERIALS CORP.) 13 September 2018, entire text | 1-4 |
| A | JP 2017-88439 A (MITSUBISHI MATERIALS CORP.) 25 May 2017, entire text | 1-4 |

☐ Further documents are listed in the continuation of Box C.    ☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 09.07.2020 | 21.07.2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

Information on patent family members

International application No.

PCT/JP2020/020292

| Patent Documents referred to in the Report | Publication Date | Patent Family | Publication Date |
|---|---|---|---|
| JP 11-343178 A | 14.12.1999 | (Family: none) | |
| JP 9-82843 A | 28.03.1997 | (Family: none) | |
| JP 2018-140929 A | 13.09.2018 | US 2020/0006213 A1 entire text WO 2018/159590 A1 EP 3590909 A1 CN 110382445 A KR 10-2019-0123727 A | |
| JP 2017-88439 A | 25.05.2017 | US 2018/0323122 A1 entire text WO 2017/077761 A1 EP 3372573 A1 CN 108137420 A KR 10-2018-0077170 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019118505 A
- JP 3211856 B
- JP 4375730 B